Europäisches Patentamt

(19) European Patent Office

Office européen des brevets

(11) Numéro de publication : **0 289 385 B1**

(12) # FASCICULE DE BREVET EUROPEEN

(45) Date de publication du fascicule du brevet :
25.09.91 Bulletin 91/39

(51) Int. Cl.⁵ : **G04G 3/00, G04F 5/14,
H03L 7/26**

(21) Numéro de dépôt : 88400900.2

(22) Date de dépôt : 14.04.88

(54) **Dispositif de référence de temps à stabilité sensiblement constante pour la mesure de temps à court et à long terme.**

(30) Priorité : 17.04.87 FR 8705525

(43) Date de publication de la demande :
02.11.88 Bulletin 88/44

(45) Mention de la délivrance du brevet :
25.09.91 Bulletin 91/39

(84) Etats contractants désignés :
AT BE CH DE ES FR GB GR IT LI LU NL SE

(56) Documents cités :
IEEE TRANSACTIONS ON NUCLEAR
SCIENCE, vol. NS-24, no. 6, décembre 1977,
pages 2252-2258, New York, US; T.M. FLANA-
GAN et al.: "Hardening frequency standards
for space applications"
NEUE UHRMACHER ZEITUNG ULM, vol. 23,
no. 14, 1969, pages 33-36; "Die Atomuhr entspricht den Bedürfnissen der modernen Wissenschaft und Technik"

(56) Documents cités :
IEEE TRANSACTIONS ON INSTRUMENTA-
TION AND MEASUREMENT, vol. IM-28, no. 3,
septembre 1979, pages 188-193, IEEE, New
York, US; J. VANIER et al.: "Transfer of frequency stability from an atomic frequency
reference to a quartz-cristal oscillator"
MICROWAVE JOURNAL, vol. 13, no. 6, juin
1970, pages 43-56; R.A. BAUGH et al.:
"Precision frequency sources"
L'ONDE ELECTRIQUE, voi. 53, no. 2, février
1973, pages 39-45, Paris, FR; C. AUDOIN:
"Revue des oscillateurs atomiques et moléculaires"

(73) Titulaire : **CENTRE NATIONAL D'ETUDES
SPATIALES**
**2 Place Maurice-Quentin**
**F-75039 Paris Cedex 01 (FR)**

(72) Inventeur : **Groslambert, Jacques**
**15, rue de la Prévoyance**
**F-25000 Besancon (FR)**
Inventeur : **Brunet, Michel**
**5, rue de ridaudin**
**F-31650 Saint Orens (FR)**

(74) Mandataire : **Schrimpf, Robert et al**
**Cabinet Regimbeau 26, Avenue Kléber**
**F-75116 Paris (FR)**

## Description

Les dispositifs actuels de référence de temps actuellement disponibles dans la technique de mesure du temps comportent une horloge de référence, délivrant un signal base de temps, laquelle est normalement choisie en fonction du domaine ou de la plage de mesure considérée, en raison des qualités non homogènes de stabilité du signal base de temps en fonction de l'utilisation considérée.

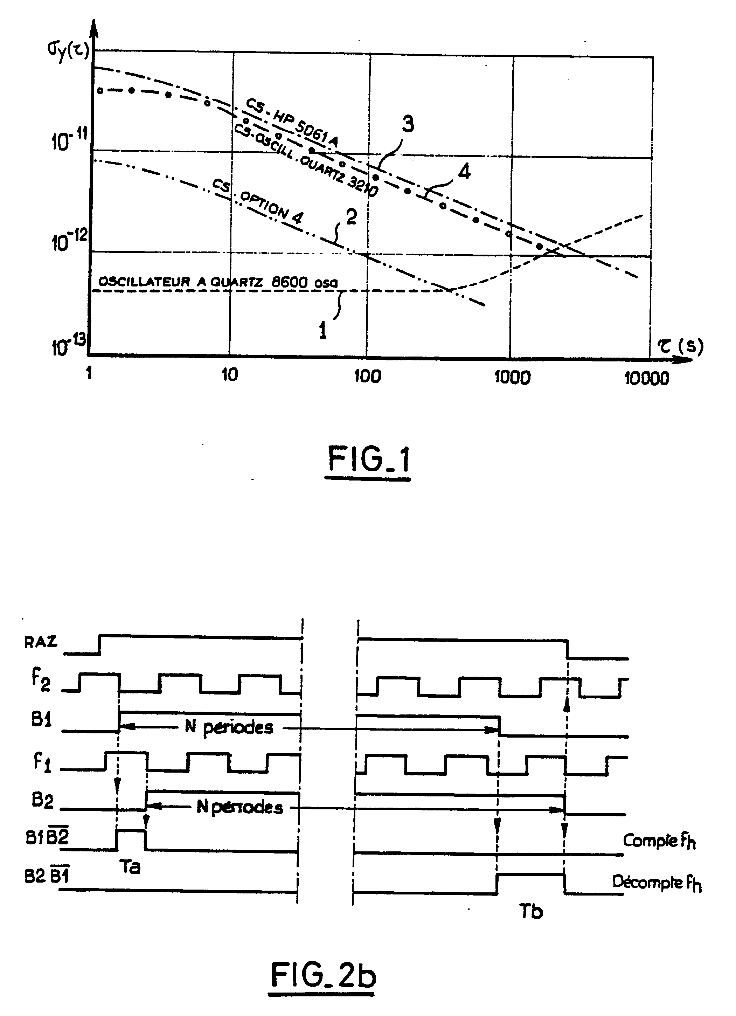

Ainsi, actuellement, l'état de la technique peut être résumé en relation avec la figure 1 par le tracé des courbes de stabilité des meilleurs oscillateurs à quartz à fréquence à 5 MHz disponibles dans le commerce, courbe ① pour un oscillateur à quartz commercialisé sous la dénomination 8600 OSA par la Société Oscilloquartz et par les courbes ② ③ et ④ relativement aux horloges au césium CS option 4, CS-HP5061A, commercialisées par la société HEWLETT-PACKARD et CS 3210 commercialisé par la société Oscilloquartz. Sur la figure 1, l'axe des abscisses est gradué en temps d'intégration ou de comptage $\tau$, plage de mesure, et l'axe des ordonnées en variance des fluctuations relatives de fréquence exprimée selon la variance d'Allan $\sigma y(\tau)$. On constate que pour la plage de mesure de temps à court terme, temps de comptage $\tau$ compris entre $10^{-3}$ s et 1000 s environ, les meilleurs oscillateurs à quartz permettent d'atteindre une stabilité en fréquence $\sigma y(\tau)$ pour laquelle la variance de fréquence est inférieure à $10^{-12}$, sensiblement, cette variance augmentant rapidement, et la stabilité en fréquence du signal base de temps se dégradant rapidement, pour un temps de comptage supérieur à 1000 secondes. Au contraire, les meilleures horloges au césium présentent une variance de fréquence très supérieure à $10^{-12}$ et donc une stabilité en fréquence médiocre du signal base de temps engendré par celles-ci pour un temps de comptage inférieur à 100 secondes, la variance de fréquence devenant au contraire inférieure à $10^{-12}$ pour un temps de comptage supérieur à environ 1000 secondes.

Ainsi, en fonction de l'application et du temps de comptage envisagé, il est nécessaire, en vue d'effectuer une mesure de temps dans des conditions de précision optimales, d'utiliser l'une ou l'autre des références de temps oscillateur à quartz ou horloge au césium et il n'existe actuellement pas de référence unique de fréquence susceptible de couvrir à la fois le domaine de mesure du court terme, temps de comptage $10^{-3} < \tau < 1000$ s et le domaine du long terme $\tau > 1000$ s.

On connaît de l'article "Hardening frequency standards for space applications" de T.M. FLANAGAN, paru dans IEEE Transactions on Nuclear Science, Vol. NS-24, n° 6, dec. 1977, pp ; 2252-2258 (New-York, US) un dispositif de référence de temps à stabilité sensiblement constante pour la mesure de temps à court terme et à long terme, comportant des premiers moyens générateurs d'un premier signal base de temps de stabilité sensiblement constante pour les mesures de temps à court terme, des deuxièmes moyens générateurs d'un deuxième signal base de temps de stabilité sensiblement constante pour les mesures de temps à long terme, des moyens d'asservissement de l'un desdits premier ou deuxième signal base de temps par rapport à l'autre deuxième ou premier signal base de temps, le premier et le deuxième signal ayant même fréquence de base ou des fréquences harmoniques. Le dispositif de référence de temps à stabilité sensiblement constante pour la mesure de temps à court et à long terme objet de l'invention a pour but de mettre en oeuvre un dispositif de ce type dont la stabilité, optimale, serait inférieure ou égale à $5 \times 10^{-13}$ pour un temps de comptage de $\tau > 1$ s.

Le but de la présente invention est la mise en oeuvre d'un dispositif de référence de temps permettant d'obtenir un signal base de temps ou signal de référence présentant à la fois la stabilité de l'oscillateur à quarts relativement aux temps de comptage inférieurs à 1000 secondes, mesures à court terme, et la stabilité de l'horloge au césium relativement au temps de comptage supérieurs à 1000 secondes, mesures à long terme.

Le dispositif de référence de temps à stabilité sensiblement constante pour la mesure de temps à court terme et à long terme, objet de l'invention, est remarquable en ce que les moyens d'asservissement présentent une constante de temps correspondant à la zone de transition entre les mesures à court et à long terme.

Le dispositif de référence de temps à stabilité sensiblement constante pour la mesure de temps objet de l'invention trouve application à l'industrie des appareils de mesure de temps de grande précision, aux instruments de navigation aérienne ou spatiale.

L'invention sera mieux comprise à la lecture de la description et à l'observation des dessins ci-après dans lesquels, outre la figure 1 relative aux caractéristiques de stabilité en fréquence des dispositifs de référence de temps de l'art antérieur et où les mêmes références représentent les mêmes éléments :

la figure 2a représente un schéma général du dispositif de référence de temps objet de l'invention dans lequel un asservissement de fréquence d'un signal base de temps sur un autre signal base de temps est réalisé,

— la figure 2b représente un chronogramme des signaux aux points de test, correspondants de la figure 2a,

— la figure 3a représente un mode de réalisation avantageux du dispositif de référence de temps objet de l'invention représenté en figure 2, dans lequel un asservissement de phase des premier et deuxième signal base de temps est réalisé,

— la figure 3b représente un chronogramme aux points de test de la figure 3a,

— la figure 4 représente un organigramme d'un programme de pilotage de la variation séquentielle de la valeur de la constante de temps des moyens d'asservissement du premier et deuxième signal base de temps pour assurer une convergence optimale de la valeur de cette constante de temps vers la valeur finale, choisie par l'opérateur en fonction du type d'oscillateur à quartz et/ou d'horloge au césium effectivement utilisé.

— la figure 5 représente un schéma illustratif de l'évolution du déphasage $\phi$ entre les signaux base de temps fb1 et fb2, lors de l'accrochage des moyens d'asservissement en phase 3 au cours du temps, la constante de temps de ces derniers étant successivement incrémentée pour atteindre la valeur finale $\tau f$ conformément à l'organigramme représenté en figure 4.

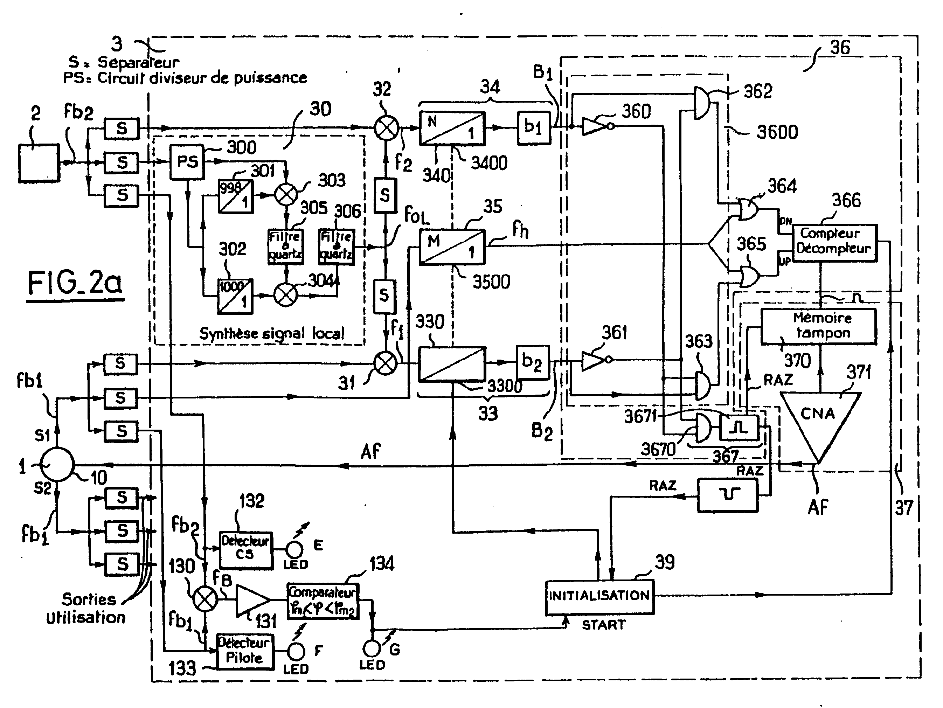

Le dispositif de référence de temps à stabilité sensiblement constante objet de l'invention, dispositif permettant la mesure du temps à court et à long terme sera tout d'abord décrit en liaison avec la figure 2a.

Ainsi qu'on l'a représenté sur la figure précitée, le dispositif objet de l'invention comprend des premiers moyens notés 1, générateurs d'un premier signal base de temps noté fb1. Les premiers moyens 1 générateurs du premier signal base de temps, délivrent un signal base de temps de stabilité sensiblement constante pour les mesures de temps à court terme. Par mesure de temps à court terme, ainsi que mentionné précédemment, on entend des mesures de temps dont les temps de comptage sont inférieurs à 1000 s. Le dispositif objet de l'invention comporte également des deuxièmes moyens notés 2 générateurs d'un deuxième signal base de temps noté fb2, de stabilité décroissant en fonction du temps de comptage $\tau$ en $\tau^{-\frac{1}{2}}$ pour les mesures de temps à long terme, les mesures de temps à long terme étant définies comme les mesures de temps pour lesquelles le temps de comptage est supérieur à 1000 s.

En outre, ainsi qu'on l'a représenté en figure 2a, des moyens 3 d'asservissement de l'un des premier ou deuxième signal base de temps par rapport à l'autre deuxième ou premier signal base de temps sont prévus. Le premier et le deuxième signal base de temps fb1, respectivement fb2, ont même fréquence, bien entendu aux fluctuations de stabilité près, et les moyens d'asservissement 3 présentent une constante de temps correspondant à la zone de transition entre les mesures à court et à long terme. Bien entendu, la zone de transition entre les mesures à court et à long terme correspond à celle que l'on obtient à l'intersection des deux courbes donnant la stabilité des premiers moyens générateurs du premier signal base de temps de stabilité sensiblement constante pour les mesures de temps à court terme et celle des deuxièmes moyens générateurs délivrant le deuxième signal base de temps de stabilité sensiblement décroissante en fonction du temps de comptage pour les mesures de temps à long terme.

L'asservissement de l'un desdits premier ou deuxième signal de base de temps par rapport à l'autre deuxième ou premier signal base de temps fb1, respectivement fb2, consiste, ainsi qu'il sera décrit ci-après plus en détail dans la description, en un asservissement de fréquence des signaux base de temps et éventuellement de phase.

Selon une mode de réalisation particulier du dispositif de référence de temps à stabilité sensiblement constante pour la mesure de temps à court et à long terme, conforme à la présente invention, le premier et le deuxième signal base de temps fb1, fb2, peuvent avoir des fréquences harmoniques, sans sortir du cadre de l'objet de la présente invention. Cependant, les modes de réalisation préférentiels du dispositif objet de l'invention seront décrits dans le cas non limitatif, où les fréquences des signaux base de temps fb1 et fb2, sont égales aux fluctuations de stabilité près.

Selon un aspect particulièrement avantageux du dispositif objet de l'invention, les premiers moyens 1 générateurs du premier signal base de temps sont constitués par un oscillateur à quartz à haute stabilité. L'oscillateur à quartz utilisé peut par exemple être un oscillateur à quartz commercialisé sous la référence 8600 OSA par la société OSCILLOQUARTZ dont la courbe de stabilité est donnée en figure 1.

De même, les deuxièmes moyens 2 générateurs du deuxième signal base de temps fb2 peuvent avantageusement être constitués par une horloge au césium par exemple l'horloge commercialisée sous la référence CS OPTION 4, par la société HEWLETT-PACKARD et dont la courbe de stabilité en fonction du temps de comptage est donnée par la courbe 2 sur la figure 1. Il est avantageux d'améliorer les performances des horloges CS HP 5061 A et CS 3210 par la mise en oeuvre du dispositif objet de l'invention.

Dans le mode de réalisation décrit en figure 2a, les premiers moyens 1 générateurs du premier signal base de temps étant constitués par un oscillateur à quartz et les deuxièmes moyens 2 générateurs du deuxième signal base de temps étant constitués par une horloge au césium, les moyens d'asservissement 3 de l'un des premier ou deuxième signal base de temps par rapport à l'autre deuxième ou premier signal base de temps, réalisent de façon avantageuse, un asservissement du premier signal base de temps fb1 par rapport au deuxième signal base de temps fb2. Dans ce cas, les premiers moyens générateurs 1 du premier signal base de temps fb1 sont constitués par un oscillateur à quartz à fréquence ajustable présentant une entrée de commande notée 10 sur la figure 2a.

Sur la figure 2a, on a représenté les premiers moyens 1 générateurs du premier signal base de temps et les deuxièmes moyens 2 générateurs du deuxième signal base de temps comportant plusieurs sorties délivrant respectivement le premier fb1, deuxième fb2 signal base de temps aux moyens d'asservissement 3, par l'intermédiaire d'étages séparateurs notés S. Ces étages séparateurs sont des étages séparateurs normalement disponibles dans le commerce et ne feront pas l'objet d'une description détaillée.

Un mode de réalisation particulièrement avantageux des moyens d'asservissement 3 sera décrit en liaison avec la figure 2a.

Selon la figure précitée, les moyens d'asservissement 3 comportent avantageusement des premiers moyens 31 de changement de fréquence du premier signal base de temps et des deuxième moyens 32 de changement de fréquence du deuxième signal base de temps fb2. Des moyens 30, générateurs d'un signal oscillateur local de référence permettent d'engendrer et de délivrer un signal d'oscillateur local de fréquence fOL commun aux premiers et deuxièmes moyens de changement de fréquence 31 et 32. Ces derniers délivrent un premier et un deuxième signal à fréquence intermédiaire de fréquence respective f1 et f2, chacun représentatif des fluctuations de la phase du premier fb1, respectivement deuxième fb2 signal base de temps. A titre d'exemple non limitatif, les premiers et deuxièmes moyens générateurs du premier fb1 et deuxième fb2 signal base de temps délivrent des signaux de fréquence base de temps égal à 5 MHz par exemple. Les moyens 30 générateurs du signal d'oscillateur local délivrent un signal fOL de fréquence voisine et les signaux à fréquence intermédiaire f1 et f2 ont une fréquence voisine de 10 Hertz. L'opération de changement de fréquence réalisée par les premiers 31 et deuxièmes 32 moyens de changement de fréquence a pour effet de conserver les relations de phase entre les signaux base de temps fb1 et fb2 au niveau des signaux à fréquence intermédiaire f1 et f2.

Les moyens 30 générateurs d'un signal oscillateur local ont la même stabilité que le deuxième signal base de temps fb2.

Selon un mode de réalisation avantageux non limitatif représenté en figure 2a, les moyens 30 générateurs du signal oscillateur local de référence fOL permettent d'engendrer ce dernier à partir du signal base de temps fb2, à 5 MHz, de l'horloge au césium constituant les deuxièmes moyens générateurs 2 du deuxième signal base de temps fb2. Le signal local de fréquence fOL est engendré par synthèse à partir du deuxième signal base de temps fb2. A cet effet, les moyens 30 générateurs du signal oscillateur local peuvent comporter avantageusement un circuit diviseur de puissance, noté 300, ou un circuit en T hybride, permettant de subdiviser le signal base de temps fb2 en deux signaux identiques de même puissance afin d'alimenter les circuits du synthétiseur. Avantageusement, le synthétiseur peut comporter un premier 301 et un deuxième 302 diviseurs de fréquence et deux circuits mélangeurs 303 et 304, lesquels reçoivent les signaux délivrés par les circuits diviseurs 301 et 302. Le premier circuit mélangeur ou de changement de fréquence 303 reçoit également l'un des signaux délivrés par le circuit diviseur de puissance 300 et délivre le signal obtenu par changement de fréquence à l'entrée du deuxième circuit de changement de fréquence 304 par l'intermédiaire d'un filtre 305. La sortie du deuxième circuit de changement de fréquence 304 délivre alors le signal oscillateur local de référence fOL par l'intermédiaire d'un filtre à quartz 306. Le signal d'oscillateur local de fréquence fOL est alors délivré par l'intermédiaire d'un étage séparateur S à l'entrée des circuits de changement de fréquence 31 et 32. Les premier et deuxième circuits diviseurs de fréquence 301 et 302 ayant des rapports de division égaux respectivement à 998 et 1000, la fréquence fOL du signal d'oscillateur local vérifie la relation :

$$fOL = fb2 + 10 \text{ Hz}.$$

L'asservissement du signal fb1 sur le signal fb2 est basé, conformément au schéma de la figure 2, sur la mesure temporelle de la durée de N battements obtenus d'une part entre la fréquence fOL du signal oscillateur local et le signal base de temps fb2. Ce signal fb2 est donc une référence qui a la stabilité correspondant à la stabilité à long terme des moyens 2 générateurs du deuxième signal base de temps, et d'autre part entre la fréquence fOL et le signal base de temps fb1 ou premier signal base de temps délivré par les moyens 1 générateurs du premier signal base de temps. Les signaux de battement ainsi obtenus ou signaux à fréquence intermédiaire sont respectivement notés f2 et f1.

Conformément à l'objet de l'invention, l'asservissement est ainsi effectué par intégration des fluctuations de phase du signal base de temps fb2 délivré par l'horloge au césium constituant les deuxièmes moyens générateurs du signal base de temps fb2 sur une durée τ égale à N/f2.

Dans ce but, les moyens d'asservissement 3 représentés en figure 2a comportent des premiers 33 et deuxièmes 34 moyens de comptage d'un nombre N de périodes du premier, respectivement deuxième signal à fréquence intermédiaire de fréquence f1, f2. Ainsi qu'on l'a représenté sur la figure 2a, les premiers 33 et deuxièmes 34 moyens de comptage du nombre N de périodes du premier, respectivement deuxième signal à fréquence intermédiaire de fréquence f1, f2 peuvent avantageusement comporter, respectivement, un diviseur programmable 330, 340 et une bascule notée respectivement b2 et b1. Bien entendu, les diviseurs programmables 330 et 340 sont identiques et leur rapport de division est programmable de 1 à N, ainsi qu'il sera décrit ultérieurement dans la description. Cette bascule b2, b1 est déclenchée au départ du comptage et reste à l'état 1 pendant les N périodes comptées des signaux à fréquence intermédiaire f2, f1. Les bascules b1 et b2 délivrent respectivement des signaux B1 et B2. Ces bascules délivrent ainsi un signal logique noté b1, b2 lequel est représentatif du comptage de N périodes du premier et du deuxième signal à fréquence intermédiaire f2, f1.

En outre, ainsi qu'on le remarquera en figure 2a, les moyens d'asservissement comportent également des moyens 35 générateurs d'un signal d'horloge de fréquence fh, dont la fréquence est une fréquence harmonique de la fréquence du premier signal base de temps fb1. Les moyens 35 générateurs du signal d'horloge fh peuvent avantageusement être constitués par un diviseur programmable, lequel divise la fréquence du signal délivré par les premiers moyens générateurs du premier signal base de temps fb1, dans un rapport programmable donné M.

En outre, les moyens d'asservissement 3 comportent également des moyens de comptage-décomptage notés 36, permettant d'établir une valeur n à partir des signaux logiques B1, B2 délivrés par les bascules b1, b2, cette valeur étant représentative de l'écart de fréquence du premier signal à fréquence intermédiaire f1, par rapport au deuxième signal à fréquence intermédiaire f2, le comptage ou le décomptage de la valeur de n étant effectué par rapport au signal d'horloge fh.

Dans ce but, les moyens de comptage-décomptage 36 recevant les signaux logiques B1, B2, délivrés par les bascules b2 des moyens de comptage 33 et b1 des moyens de comptage 34, peuvent avantageusement comporter, sur une première entrée recevant les signaux logiques B1, un inverseur 360 et une porte ET 362, dont une entrée reçoit les signaux logiques B1 précités, et sur une deuxième entrée recevant les signaux logiques B2, un inverseur 361 et une porte ET 363, dont une entrée reçoit les signaux logiques B2 précités. En outre les moyens de comptage-décomptage comportent également deux portes OU 364 et 365, une entrée des portes OU précitées recevant le signal d'horloge fh, l'autre entrée de la porte OU 364 recevant les signaux délivrés par la sortie de la porte ET 362, et l'autre entrée de la porte OU 365, recevant les signaux délivrés par la sortie de la porte ET 363. Le circuit constitué par les inverseurs 360, 361 et les portes ET 362, 363 permettent de constituer un circuit logique noté 3600, permettant d'élaborer les signaux logiques B1.$\overline{B2}$ et B2.$\overline{B1}$, produit logique des signaux B1 et $\overline{B2}$ et de B2 et $\overline{B1}$, respectivement.

Un compteur-décompteur 366 reçoit sur l'entrée de comptage le signal logique délivré par le deuxième porte OU 365 et sur l'entrée de décomptage le signal délivré par la première porte OU 364.

De même, ainsi qu'on le remarquera sur la figure 2a, les moyens d'asservissement 3 et en particulier les moyens de comptage-décomptage 36 comportent également un circuit 367 générateur d'impulsions de fin de comptage des N périodes délivrant en fin de comptage des N périodes précitées du premier et du deuxième signal à fréquence intermédiaire f1, f2 une impulsion de réinitialisation ou remise à zéro notée RAZ. La fonction de l'impulsion de réinitialisation ou remise à zéro RAZ sera décrite ultérieurement dans la description.

Enfin, les moyens d'asservissement 3 comportent également, ainsi que représenté en figure 2a, des moyens 37 générateurs d'un signal analogique Af, représentatif de l'écart de fréquence et de phase entre les premier et deuxième signal à fréquence intermédiaire f1, f2. Les moyens 37 générateurs délivrent le signal analogique Af à l'entrée de commande 10 de l'oscillateur à quartz à fréquence ajustable. De manière avantageuse, les moyens 37 générateurs du signal analogique Af peuvent consister en une mémoire tampon notée 370, laquelle reçoit le signal numérique délivré par le compteur-décompteur 366 et en un convertisseur numérique-analogique noté 371.

Le fonctionnement des moyens d'asservissement 3 décrit précédemment en liaison avec la figure 2a sera maintenant décrit en liaison avec la figure 2b.

Le compteur-décompteur 366 qui joue le rôle d'accumulateur est prépositionné au milieu de sa capacité, le bit de poids le plus élevé étant positionné à la valeur 1 et les autres bits à la valeur 0. Le compteur-décompteur 366 reçoit le signal à fréquence d'horloge fh et compte et décompte suivant l'état des bascules b1 et b2.

Pour la compréhension du fonctionnement du système d'asservissement représenté en figure 2a, on pourra se reporter utilement au chronogramme des signaux représentés en figure 2b, lequel représente un fonctionnement du dispositif tel que représenté en figure 2a dans lequel l'asservissement est un asservissement en fréquence. Sur la figure 2b, on a respectivement représenté successivement le signal de remise à zéro délivré par le circuit 367 générateur d'impulsions, le signal f2, signal à fréquence intermédiaire délivré par les deuxièmes moyens de changement de fréquence 32, le signal B1 délivré par la bascule b1 des moyens de comptage 34, le signal à fréquence intermédiaire f1 délivré par les premiers moyens de changement de fréquence 31, le signal B2 délivré par la bascule b2 des premiers moyens de comptage 33. Le produit logique des signaux B1.$\overline{B2}$ et B2.$\overline{B1}$ est également représenté sur la figure 2b, ces signaux lorsqu'ils sont en état logique 1, c'est-à-dire pendant une durée Ta pour le signal logique B1.$\overline{B2}$ et Tb pour le signal logique B2.$\overline{B1}$, permettant respectivement d'enclencher le comptage puis le décomptage du compteur décompteur 366.

Le premier signal base de temps fb1 est asservi au deuxième signal base de temps fb2, asservi en fréquence, lorsque la durée Ta est égale à la durée Tb, les signaux à fréquence intermédiaire f1 et f2, ayant le même écart de phase que les signaux base de temps fb1 et fb2 et pouvant avoir une phase quelconque. L'asservissement ainsi réalisé, tel que représenté en figure 2a, est ainsi un asservissement en fréquence.

En outre, les moyens d'asservissement comportent également un circuit 39 d'initialisation dont le mode de fonctionnement sera décrit ultérieurement dans la description, ce circuit d'initialisation permettant entre autre de fixer la valeur des diviseurs programmables 330, 340 et 35, par exemple. Le circuit générateur d'impulsions de fin de comptage 367 permet après le décompte des N périodes des signaux à fréquence intermédiaire f1 et f2 de rafraîchir la valeur du paramètre n représentatif de l'écart de fréquence du premier signal à fréquence intermédiaire f1 par rapport au deuxième signal à fréquence intermédiaire f2, par inscription de la valeur de ce paramètre dans la mémoire tampon 370 et déclenchement de la conversion numérique-analogique en 371.

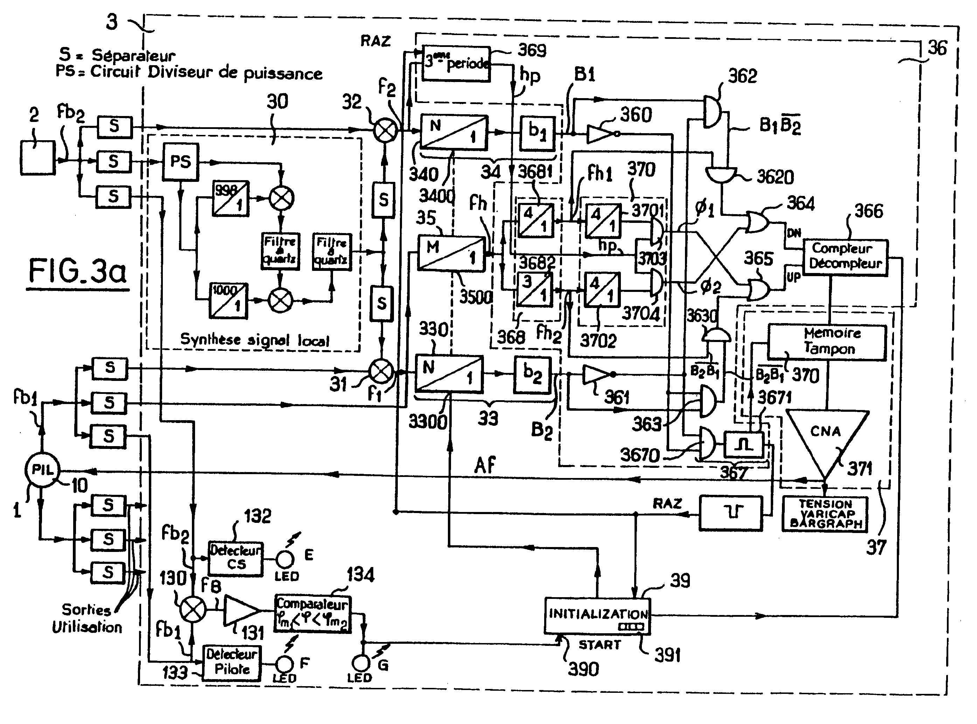

Un mode de réalisation plus particulièrement avantageux des moyens d'asservissement 3 du dispositif objet de l'invention sera décrit en liaison avec la figure 3a, dans le cas où les moyens d'asservissement permettent d'assurer un asservissement en fréquence et en phase du signal base de temps fb1 par rapport au signal base de temps fb2. Dans la figure 3a, les mêmes références représentent les mêmes éléments que dans la figure 2a.

Dans le but d'assurer l'asservissement en phase précité, les moyens de comptage-décomptage 36 comportent en outre un circuit 368 duplicateur du signal de fréquence d'horloge fh permettant d'engendrer un premier fh1 et un deuxième fh2 signal d'horloge dupliqué de fréquence différente. Le circuit 368 ainsi que représenté en figure 3a, peut comprendre avantageusement un premier circuit diviseur de fréquence noté 3681 permettant d'engendrer le signal d'horloge fh1 et un deuxième circuit diviseur de fréquence noté 3682, permettant d'engendrer le signal d'horloge fh2. Les signaux d'horloge fh1 et fh2 engendrés à partir du signal d'horloge de fréquence fh précédemment décrit ont des fréquences différentes. A titre d'exemple non limitatif, le circuit diviseur de fréquence 3681 est un diviseur par quatre et le circuit diviseur de fréquence 3682 est un circuit diviseur par trois.

En outre, ainsi qu'il apparaît en figure 3a, les moyens de comptage-décomptage 36 comportent également des moyens 369 de discrimination d'une période parmi p du deuxième signal à fréquence intermédiaire f2. Dans le mode de réalisation décrit en figure 3a, les moyens de discrimination d'une période parmi p permettent en fait de discriminer une période parmi les 3 premières et sont constitués par un circuit du type bascule, permettant d'engendrer un signal logique hp d'état logique constant, pendant toute la durée de la période d'ordre p ainsi discriminée, dans le cas particulier de la figure 3a, la troisième période.

Ainsi qu'on l'a également représenté en figure 3a, les moyens de comptage-décomptage 36 comportent également des moyens 370 de comptage pendant la période d'ordre p précitée, la période d'ordre 3, d'un nombre Nφ de périodes de chacun des premiers fh1 et deuxième fh2 signal d'horloge dupliqué, de façon à délivrer un premier et un deuxième signal de consigne de phase notés φ1 et φ2. Selon le mode de réalisation de la figure 3a, les moyens 370 de comptage comportent avantageusement un premier diviseur de fréquence 3701 recevant le signal d'horloge dupliqué fh1, le circuit diviseur de fréquence étant dans le mode de réalisation de la figure 3a constitué par un diviseur par quatre. Les moyens 370 de comptage comportent également un deuxième circuit diviseur de fréquence noté 3702 recevant le signal d'horloge dupliqué fh2, le deuxième diviseur de fréquence 3702 constituant un diviseur de fréquence par quatre. Deux circuits ET 3703 et 3704 reçoivent respectivement le signal à fréquence divisé délivré par le diviseur de fréquence 3701, et le signal à fréquence divisé délivré par le diviseur de fréquence 3702, chaque circuit ET recevant également en commun le signal logique hp d'état déterminé délivré par les moyens 369 de discrimination d'une période parmi p. Les sorties des circuits ET 3703 et 3704 délivrent alors respectivement un premier et un deuxième signal de consigne de phase φ1 et φ2, le signal de consigne de phase φ1 étant délivré à l'entrée de la deuxième porte OU 365 et le signal de consigne de phase φ2 étant délivré à l'entrée de la première porte OU 364.

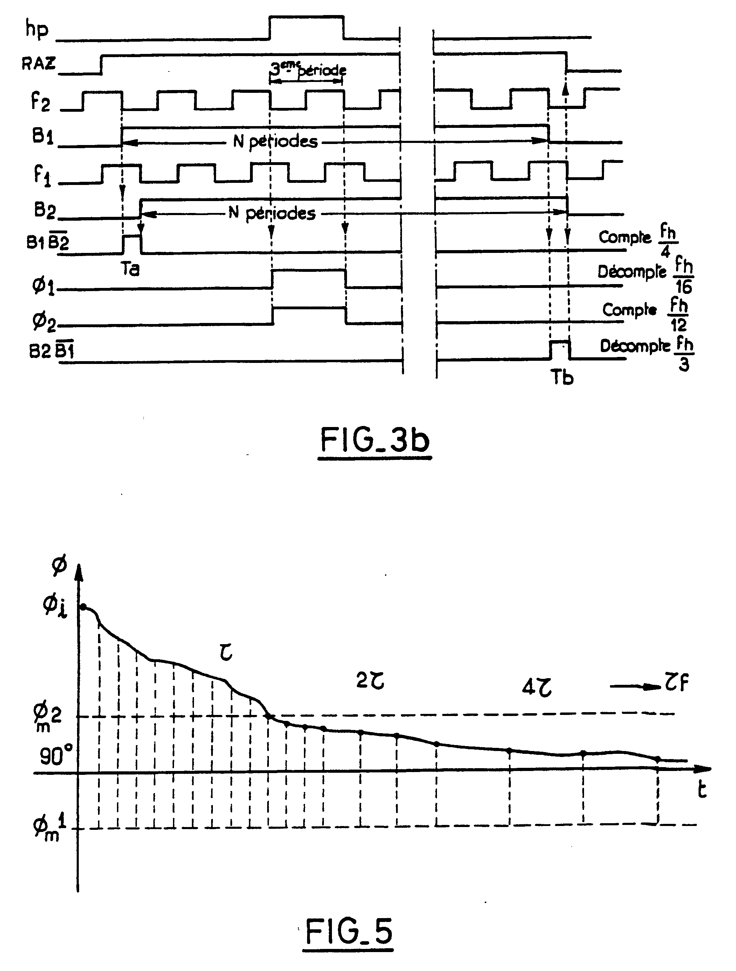

L'utilisation de deux fréquences d'horloge différentes, les fréquences d'horloge dupliquées fh1, fh2 respectivement égales à fh/4 et fh/3 ainsi que décrit précédemment permet de réaliser l'asservissement en phase du premier signal à fréquence base de temps fb1 sur le deuxième signal base de temps fb2, ainsi qu'il sera décrit en liaison avec la figure 3b.

Sur la figure 3b on a successivement représenté le signal hp de discrimination d'une période, la troisième période-du signal à fréquence intermédiaire f2, le signal de remise à zéro RAZ, le signal à fréquence intermédiaire f2 délivré par les deuxièmes moyens de changement de fréquence 32, le signal B1 délivré par la bascule b1 des moyens de comptage 34, le signal f1 à fréquence intermédiaire délivré par le premier moyen mélangeur 31, le signal B2 délivré par la bascule b2 des premiers moyens de comptage 33, le signal logique $B1.\overline{B2}$ délivré par la porte ET 362 puis encore successivement le signal de consigne de phase φ1 délivré par la porte ET 3703, lequel correspond à un signal de commande de décompte à fréquence fh/16 pendant la troisième période du signal à fréquence intermédiaire f2, c'est-à-dire pendant l'état logique 1 ou haut du signal hp et le signal de consigne de phase $\phi2$, lequel correspond à une commande de compte à fréquence fh/12, délivré par la sortie de la porte ET 3704 pendant la troisième période du signal à fréquence intermédiaire f2 représenté par le signal hp puis enfin le signal B2.$\overline{\text{B1}}$.

Sur la figure 3b, le signal B1.$\overline{\text{B2}}$ correspond à une commande de compte du compteur-décompteur 366 à la fréquence fh/4 pendant la durée Ta, le signal $\phi1$ correspond à un décompte du même compteur-décompteur 366 à la fréquence fh/16, pendant la troisième période, le signal de consigne de phase $\phi2$ correspond à un compte du compteur-décompteur 366 à la fréquence fh/12 pendant cette même troisième période du signal à fréquence intermédiaire f2, et le signal B2.$\overline{\text{B1}}$ correspond à un décompte du compteur-décompteur 366 pendant une durée Tb à la fréquence fh/3.

Ainsi qu'on le remarquera en outre en figure 3a, afin d'assurer et de permettre au compteur-décompteur 366 de réaliser les comptes et décomptes précités sur commande des signaux B1.$\overline{\text{B2}}$, $\phi1$, $\phi2$, B2.$\overline{\text{B1}}$, les moyens 36 de comptage-décomptage comportent respectivement deux portes ET supplémentaires 3620 et 3630, dont les entrées reçoivent le signal B1.$\overline{\text{B2}}$ et le signal fh1, signal d'horloge dupliqué, respectivement le signal B2, $\overline{\text{B1}}$ et le signal fh2 autre signal d'horloge dupliqué. Les sorties des portes ET 3620 et 3630 sont connectées respectivement à une entrée des portes OU 364, respectivement 365, l'autre entrée des portes OU 364 et 365 recevant les sorties des portes ET 3704 et 3703, délivrant respectivement les signaux de consigne de phase $\phi2$ et $\phi1$ précédemment décrits. Bien entendu, comme précédemment, les sorties des portes OU 364 et 365 sont connectées sur l'entrée de décomptage respectivement de comptage du compteur-décompteur 366.

Dans le cas du diagramme d'état de la figure 3a, tel que représenté en figure 3b, l'asservissement en fréquence et en phase des signaux fb1, premier signal base de temps et fb2, deuxième signal base de temps est réalisé lorsque les durées Ta et Tb des signaux B1.$\overline{\text{B2}}$ et B2.$\overline{\text{B1}}$ vérifient les relations :

$$Ta \times \frac{fh}{4} = Tb \times \frac{fh}{3}$$

Une première solution dans laquelle Ta égale 4/3 de Tb est une solution instable et une deuxième solution Ta = Tb = 0 est également une solution dans laquelle les signaux base de temps fb1 et fb2 sont en phase, cette solution étant également instable. En effet, un léger retard de phase $\varepsilon$ sur l'un des signaux apparaît comme un écart apparent de 360° − $\varepsilon$, ce qui produit le décrochage de l'asservissement.

Afin de remédier à l'inconvénient précité, le dispositif objet de l'invention tel que représenté en figure 3a permet de réaliser un asservissement de phase à 90°. Dans ce cas, de manière avantageuse, les durées Ta et Tb des signaux B1.$\overline{\text{B2}}$ et B1.$\overline{\text{B2}}$ sont prises égales au quart de la période du deuxième signal à fréquence intermédiaire f2, ces durées vérifiant la relation : Ta = Tb = T2/4. Dans ce cas, le comptage et le décomptage s'effectuent à deux fréquences différentes fh/4 et fh/3, respectivement pendant les durées T2 et T1 où T2 et T1 représentent chacune la période des signaux à fréquence intermédiaire deuxième signal à fréquence intermédiaire f2 et premier signal à fréquence intermédiaire f1. A la quadrature de phase, le résultat du compteur-décompteur 366 jouant le rôle d'accumulateur est alors :

$$\frac{fh}{4} \times \frac{T2}{4} - \frac{fh}{3} \times \frac{T2}{4}.$$

Pour que le résultat de comptage du compteur décompteur soit inchangé, il suffit alors de compter et de décompter pendant une période T2/4, les signaux de fréquence fh/4 et fh/3. En l'absence d'un signal de période T2/4, compte-tenu du fait que l'on dispose d'un signal de période T2, il suffit donc de compter et de décompter pendant la période T2 des fréquences quatre fois plus faibles, soit fh/16 et fh/12.

La période choisie pour effectuer le comptage précité est la troisième période de T2, c'est-à-dire la troisième période du deuxième signal à fréquence intermédiaire f2, de façon qu'il n'y ait pas de recouvrement avec le signaux B1.$\overline{\text{B2}}$, ou B2.$\overline{\text{B1}}$.

Le signal à fréquence base de temps fb1, premier signal base de temps, est alors asservi en quadrature de phase sur le signal base de temps fb2, deuxième signal base de temps, lorsque la relation ci-après est vérifiée :

$$Ta \times \frac{fh}{4} - Tb \times \frac{fh}{3} + T2 \times \frac{fh}{12} - T2 \times \frac{fh}{16} = 0$$

$$\text{soit pour } Ta = Tb = \frac{T2}{4}.$$

La plage d'accrochage d'un système asservi en phase est inversement proportionnelle à la constante de temps du dispositif d'asservissement. Elle devient très faible, de l'ordre de $2 \times 10^{-10}$ en valeur relative pour une constante de temps élevée voisine de 1000 s. Un système de type analogique, c'est-à-dire à constante de temps préfixée ne peut donc satisfaire aux conditions d'accrochage et de maintien dans les conditions habituelles de fonctionnement du dispositif objet de l'invention, pour lequel justement, la constante de temps doit être adaptée en fonction du temps de mesure ou de comptage.

Afin de remédier à la difficulté précitée, le dispositif objet de l'invention prévoit la mise en oeuvre de moyens d'asservissement à constante de temps séquentiellement variable. Ainsi, l'asservissement s'effectue tout d'abord sur une constante de temps faible de l'ordre de 25 s puis cette dernière est progressivement doublée à chaque fois que l'asservissement en fréquence et en phase du système est réalisé pour atteindre la valeur la plus proche de celle recherchée. Bien entendu, la constante de temps finale est choisie par l'utilisateur au moyen d'un système de présélection de celle-ci, système qui sera décrit ci-après dans la description.

Ainsi qu'on le remarquera en figure 2a et 3a notamment, en vue de permettre la mise en oeuvre de moyens d'asservissement à constante de temps séquentiellement variable, les premiers 33 et deuxièmes 34 moyens de de comptage et les moyens 35 générateurs du signal d'horloge fh comportent un diviseur de fréquence programmable dont le port d'entrée noté respectivement 3300, 3400, 3500 est relié à un circuit de commande, le circuit d'initialisation 39 précédemment décrit.

Conformément à un aspect du dispositif objet de l'invention particulièrement avantageux, en vue d'assurer le pilotage de la constante de temps des moyens d'asservissement 3 selon une séquence de variation déterminée, le circuit de commande 39 est constitué par un circuit logique de commande à logique câblée ou par un microprocesseur.

Ainsi qu'on l'a en outre représenté en figure 2a et 3a, et en vue d'assurer le pilotage de la constante de temps des moyens d'asservissement 3 selon une séquence de variation déterminée, les moyens d'asservissement 3 comportent en outre des troisièmes moyens de changement de fréquence 130, recevant d'une part le premier fb1 et deuxième fb2 signal base de temps, pour délivrer un signal de battement noté fB dont l'amplitude est proportionnelle à la phase φ du premier par rapport au deuxième signal base de temps fb1, fb2, ceux-ci étant asservis en fréquence. Des moyens amplificateurs 131 sont en outre prévus, afin de permettre d'obtenir un signal de battement fB amplifié.

En outre, ainsi qu'on le remarquera sur la figure 3a, des moyens comparateurs 134 à double seuil de valeur de phase φm1 et φm2 sont prévus, ces moyens comparateurs 134 délivrant un signal logique à deux états, un premier état correspondant à une valeur de phase φ comprise entre les valeurs de seuil de phase φm1 et φm2 et un deuxième état complémenté par rapport au premier état, correspondant à une valeur de phase φ extérieure à l'intervalle de phase défini par les valeurs de seuil de phase φm1 et φm2. Le signal logique délivré par le comparateur 134 est délivré à un port d'entrée 390 du circuit de commande ou d'initialisation 39 de façon à permettre un asservissement de la valeur de phase φ entre les deux valeurs de seuil de phase φm1 et φm2. Sur la figure 3a, on remarquera également que certains dispositifs auxiliaires ont été prévus, ces dispositifs auxiliaires pouvant consister par exemple en un détecteur 132 permettant de détecter la présence du signal base de temps fb2, détecteur auquel est associé une diode électroluminescente, permettant de témoigner de la présence du signal base de temps fb2, et un détecteur 133 permettant de détecter la présence du signal fb1 auquel est associé la diode électroluminescente correspondante, permettant de témoigner de la présence du signal base de temps fb1. De la même façon, le comparateur ou la sortie de celui-ci reliée au port d'entrée 390 du circuit d'initialisation ou de commande 39, peut être muni d'une diode électroluminescente témoin permettant de témoigner de l'asservissement en phase.

Selon une caractéristique avantageuse du dispositif objet de l'invention représenté en figure 3a, le circuit de commande 39 comporte un système de codage 391 par l'opérateur utilisateur du dispositif de la valeur finale τf de la constante de temps finale des moyens d'asservissement 3. Les moyens de codage 391 peuvent par exemple être constitués par une roue codeuse permettant l'affichage d'un chiffre D compris entre 0 et 7 par exemple, la constante de temps finale τf étant alors définie par la valeur $\tau f = 25 \times 2^D$ s.

Le circuit de commande 39 muni de son microprocesseur ou du circuit de logique câblé permet d'assurer à partir de la valeur initiale de déphasage φi entre les premier et deuxième signal base de temps fb1, fb2 une convergence optimale d'accrochage de l'asservissement 3 par modification séquentielle de la valeur de la constante de temps τj pour atteindre la valeur finale τf, la valeur de déphasage φ étant maintenue dans l'intervalle défini par les valeurs de seuil de phase φm1 et φm2.

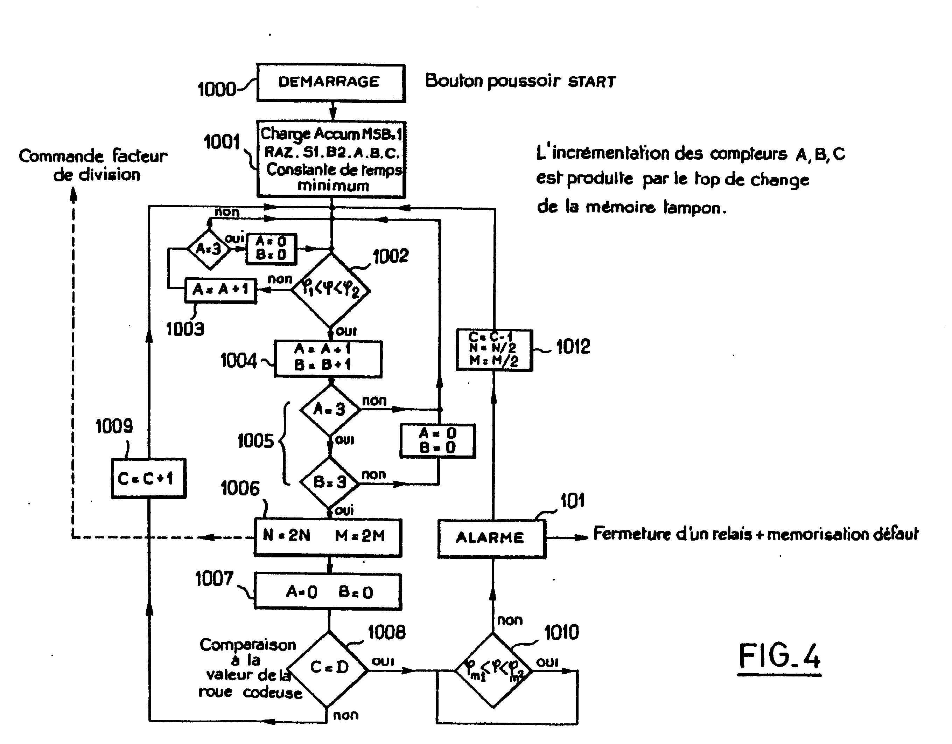

Un exemple de mode de réalisation plus particulièrement avantageux du dispositif ou circuit de commande 39, lorsque celui-ci est constitué par un microprocesseur sera donné en liaison avec la figure 4.

Dans le cas de la figure précitée, le microprocesseur comporte une mémoire morte associée dans laquelle un programme de pilotage de variation séquentielle des rapports de division N des premiers 33 et deuxièmes 34 moyens de comptage d'un nombre N de période du premier f1, respectivement deuxième f2 signal de fréquence intermédiaire et M des moyens 35 générateurs du signal d'horloge fh est implanté. Selon la figure 4 précitée, le programme comporte une étape de mise en route 1000 et d'initialisation 1001 déclenchée par l'opérateur sur mise en marche du dispositif par l'intermédiaire du dispositif de commande 39. Au cours des étapes 1000 et 1001 précitées, le dispositif est initialisé par un bouton-poussoir "start" c'est-à-dire que les compteurs sont mis à zéro, les diviseurs programmables sont prépositionnés sur les valeurs N et M correspondants et le compteur-décompteur 366 est positionné au milieu de sa capacité totale, le bit de poids le plus élevé étant positionné à 1 et les autres bits à 0. La valeur du compteur-décompteur 366 est alors transférée à la mémoire 370, cette valeur étant alors appliquée par l'intermédiaire du convertisseur numérique analogique CNA 371 sur l'entrée de commande 10 de l'oscillateur à quartz constituant les premiers moyens permettant d'engendrer le signal base de temps fb1. Cette entrée est alors polarisée à la tension voisine de 5 volts. Le maintien du bouton-poussoir "start" enfoncé bloque le système, tout en appliquant cette tension maximale sur l'entrée de commande 10. Ceci permet d'assurer un réglage de l'accord mécanique de fréquence de l'oscillateur à quartz pour l'approcher de la fréquence de l'horloge au césium constituant les deuxièmes moyens générateurs du signal base de temps fb2. Le contrôle de cet accord se fait par visualisation de la phase sur l'indicateur constitué des diodes électroluminescentes connecté en sortie du comparateur 134. Cet accord n'est pas critique, le dispositif admettant un écart relatif de plus ou moins $10^{-8}$. Le positionnement des diviseurs 330, 340, 35 à leur valeur minimale de façon à initialiser la constante de temps $\tau$ des moyens d'asservissement 3 à sa valeur initiale $\tau$ minimale est également réalisé. Le système permet également l'initialisation de variable de comptage A, B, C, ces variables étant définies comme

A : l'ordre de la séquence de mesure de la valeur de n représentative de l'écart de fréquence ou de phase du premier et deuxième signal à fréquence intermédiaire, une séquence de mesure correspondant à l'intervalle de temps entre deux impulsions d'écriture de la valeur n en mémoire tampon 370,

B : l'ordre de la séquence de mesure de la valeur n pour laquelle le déphasage $\phi$ est compris entre les valeurs de seuil de déphasage $\phi$m1 et $\phi$m2,

C : le paramètre de définition de la valeur actuelle de la constante de temps en seconde de $\tau$j de l'asservissement défini par $\tau j = 25 \times 2^C$.

Lorsque le bouton starter est relâché, les diviseurs par N deviennent actifs, le signal B1 passant à la valeur 1 par le premier flanc descendant du signal à fréquence intermédiaire f2 puis B2 par le premier flanc descendant du signal à fréquence intermédiaire de f1 ou inversement suivant la phase entre les signaux base de temps fb1 et fb2. Le comptage et le décomptage s'effectuent alors. Après N périodes, il y a repositionnement des diviseurs programmables, charge du contenu du compteur-décompteur 366 dans la mémoire tampon 370, variation de la tension de commande analogique Af appliquée à l'entrée 10 de commande de l'oscillateur à quartz 1.

Suite aux étapes de démarrage 1000 et initialisation 1001 précédemment décrites, le programme comporte ensuite ainsi que représenté en figure 4, une étape de test notée 1002 sur la valeur de déphasage $\phi$ entre le premier fb1 et le deuxième fb2 signal base de temps par rapport aux deux valeurs de seuil

de phase $\phi$m1, $\phi$m2, ce test constituant un test d'accrochage en phase. Une réponse négative au test d'accrochage en phase 1002 permet après incrémentation du compteur A d'effectuer une nouvelle séquence de mesure par retour en situation antérieure au test sur la phase 1002, alors qu'une réponse positive au test précité permet de passer à une étape de vérification d'accrochage de l'asservissement en phase. En cas de réponse positive au test 1002 d'accrochage en phase, une étape d'incrémentation 1004 des paramètres A et B permet le passage à une mesure successive et un test 1005 de stabilisation de phase sur le nombre N$\phi$ de mesures pour lesquelles le test d'accrochage en phase 1002 est satisfait, une réponse négative au test 1005 de stabilisation de phase permettant le retour à une situation de nouvelles mesures préalable au test 1002. Sur réponse positive au test de stabilisation de phase 1005, une étape 1006 d'incrémentation des rapport de division N et M des premiers 33 et deuxièmes 34 moyens de comptage des moyens 35 générateurs du signal d'horloge fh est alors prévue. L'étape d'incrémentation est notée 1006 et elle est suivie d'une étape de réinitialisation 1007 des paramètres A et B. L'étape de réinitialisation 1007 est elle-même suivie d'une étape de test 1008 de comparaison de C, représentative de la valeur de la constante actuelle $\tau$j de l'asservissement à la valeur finale D introduite par codage par l'opérateur. Une réponse négative au test 1008 conduit à une étape d'incrémentation de C puis à un retour à une étape de mesure de phase préalable au test de comparaison de phase 1002 et une réponse positive au test 1008 conduit à un nouveau test 1010 de comparaison de la valeur de phase $\phi$ aux valeurs de seuil de phase $\phi$m1 et $\phi$m2. Une réponse positive au test 1010 de comparaison de phase ramène à une étape de nouveau test 1010, le système étant asservi, et une réponse négative au test 1010 conduit à une étape de décrémentation 1012 du paramètre C, de façon que le système soit ramené en situation antérieure, la valeur de la constante de temps des moyens d'asservissement 3 étant ramenée à la valeur $\tau$j-1 égale $\tau j - 1 = 25 \times 2^{C-1}$. Le système est alors ramené suite à la décrémentation 1012 à une étape de mesure de phase antérieure à la situation de test 1002.

En pratique, on remarquera que l'impulsion d'initialisation ou de remise à zéro délivrée par le circuit 367 à la mémoire tampon 370 notamment, permet, soit l'incrémentation des deux compteurs A et B, à l'étape 1004 si la phase $\phi$ entre le signal base de temps fb1 et le signal base de temps fb2 est comprise entre les deux limites fixées sur le comparateur $\phi$m1 et $\phi$m2, $\phi$m1 et $\phi$m2 étant pris égal par exemple à 90° $- \varepsilon$ et $\phi$m2 étant pris égal à 90° $+ \varepsilon$, soit l'incrémentation du seul compteur A en 1003, si la phase $\phi$ est en dehors de cette plage.

Le test A = B = 3 en 1005, signifie que pendant trois mesures successives la phase $\phi$ est restée entre les limites fixées $\phi$m1, $\phi$m2, cette phase étant alors considérée comme stabilisée.

L'impulsion délivrée par le circuit 367, constituant impulsion de commande de charge de la mémoire tampon 370, commande également le changement des facteurs de division des diviseurs par N et par M, diviseurs programmables 330, 340 et 35, respectivement. Cette commande peut être réalisée par tout moyen, en particulier grâce au microprocesseur, lequel peut commander directement les diviseurs programmables. Ces diviseurs passent alors à la valeur de N et M, respectivement. La variable de comptage C est comparée à la valeur D affichée par l'opérateur sur les roues codeuses, si C est inférieur à D, les compteurs A et B étant remis à zéro, le processus repart pour effectuer des mesures sur 2N périodes. Si pendant trois mesures la phase reste dans la plage fixée, C est alors incrémenté et ceci jusqu'à ce que C = D. Le système reste dans cet état tant que $\phi$ reste dans la plage permise, sinon, une alarme est déclenchée par fermeture d'un relais et un défaut mémorisé par bascule est visualisé par l'intermédiaire de la diode électroluminescente, ainsi que décrit précédemment.

Si le système décroche, cela signifie que la constante de temps choisie est trop élevée et il suffit de diminuer la valeur D de la roue codeuse.

Sur la figure 5, on a représenté de manière schématique et illustrative, la loi de convergence de la phase $\phi$ en fonction du temps, pour une constante de temps $\tau$, $2\tau$, $4\tau$ de l'asservissement. La constante de temps étant ainsi incrémentée après trois mesures successives montrant que la valeur de phase $\phi$ est comprise dans la bande ou plage de consigne constituée par les valeurs $\phi$m1 et $\phi$m2.

L'asservissement tel que représenté en figure 3a permet ainsi d'obtenir une loi de convergence de la phase entre le signal base de temps fb1 et le signal base de temps fb2 optimalisé, dans la mesure où le temps de convergence par rapport à un système habituel est sensiblement divisé par deux. En outre, compte tenu de la plage de variation de la constante de temps $\tau$, le dispositif objet de l'invention permet une souplesse d'utilisation très importante, le dispositif objet de l'invention constituant une référence à court et à long terme dont la stabilité de 1 à 1000 s est celle d'un oscillateur à quartz libre, et dont la stabilité pour les mesures à long terme est celle d'une horloge au césium.

Un prototype de ce dispositif a été réalisé et des essais comparatifs par rapport à un oscillateur à quartz et à un maser à hydrogène ont montré des caractéristiques de stabilité définies à partir de la variance d'Allan par rapport au maser à hydrogène satisfaisantes.

Outre les applications précédemment mentionnées, le dispositif de référence de temps à stabilité sensiblement constante pour la mesure de temps à court et à long terme objet de l'invention, peut avantageusement être utilisé dans le domaine de la métrologie scientifique et opérationnelle, en géodésie, pour la localisation-navigation et la synchronisation des réseaux de télécommunication.

De la même manière, le dispositif objet de l'invention peut être utilisé dans le domaine aérospatial pour la synchronisation à un signal hertzien se propageant dans le sens espace-terre ou terre-espace.

Cette dernière application est possible car le dispositif objet de l'invention conserve les propriétés spectrales de l'oscillateur asservi, l'oscillateur à quartz, et notamment les propriétés de rapport signal à bruit de celui-ci.

## Revendications

1. Dispositif de référence de temps à stabilité sensiblement constante pour la mesure de temps à court et à long terme, comportant :

— des premiers moyens (1) générateurs d'un premier signal base de temps (fb1) de stabilité sensiblement constante pour les mesures de temps à court terme,

— des deuxièmes moyens (2) générateurs d'un deuxième signal base de temps (fb2) de stabilité sensiblement constante pour les mesures de temps à long terme,

— des moyens (3) d'asservissement de l'un desdits premier ou deuxième signal de base de temps par rapport à l'autre deuxième ou premier signal de base de temps, ledit premier (fb1) et deuxième (fb2) signal de base de temps, ayant même fréquence de base ou des fréquences harmoniques, caractérisé en ce que lesdits moyens (3) d'asservissement présentent une constante de temps correspondant à la zone de transition entre les mesures à court et à long terme.

2. Dispositif selon la revendication 1, caractérisé en ce que lesdits premiers moyens (1) générateurs du premier signal base de temps sont constitués par un oscillateur à quartz à haute stabilité.

3. Dispositif selon l'une des revendications 1 ou 2, caractérisé en ce que lesdits deuxièmes moyens (2) générateurs du deuxième signal base de temps sont constitués par une horloge à césium.

4. Dispositif selon l'une des revendications 2 et 3 précédentes, caractérisé en ce que lesdits moyens d'asservissement (3) de l'un desdits premier ou deuxième signal base de temps par rapport à l'autre deuxième ou premier signal base de temps réalisent un asservissement dudit premier signal base de temps (fb1) par rapport audit deuxième signal base de temps (fb2), lesdits premiers moyens générateurs du premier signal base de temps étant constitués par un oscillateur à quartz à fréquence ajustable présentant une entrée de commande (10).

5. Dispositif selon la revendication 4, caractérisé en ce que lesdits moyens d'asservissement comportent :

    — des premiers moyens (31) de changement de fréquence du premier signal base de temps,

    — des deuxièmes moyens (32) de changement de fréquence du deuxième signal base de temps,

    — des moyens (30) générateurs d'un signal oscillateur local de référence permettant d'engendrer et délivrer un signal d'oscillateur local de fréquence foL commun aux-dits premiers et deuxièmes moyens de changement de fréquence lesquels délivrent un premier et un deuxième signal à fréquence intermédiaire de fréquence respective f1 et f2 chacun représentatif de la fréquence et de la phase dudit premier (fb1),respectivement deuxième (fb2) signal base de temps,

    —-des premiers (33) et de deuxièmes (34) moyens de comptage d'un nombre N de périodes dudit premier respectivement deuxième signal à fréquence intermédiaire de fréquence (f1, f2), délivrant un signal logique (B1, B2) représentatif du comptage des N périodes du premier et deuxième signal à fréquence intermédiaire (f1, f2),

    — des moyens (35) générateurs d'un signal d'horloge (fh) dont la fréquence est une fréquence harmonique de la fréquence du premier signal base de temps (fb1),

    — des moyens de comptage-décomptage (36) permettant d'établir une valeur n représentative de l'écart de fréquence ou de phase du premier signal à fréquence intermédiaire par rapport au deuxième signal à fréquence intermédiaire, le comptage ou le décomptage étant effectué par rapport au signal d'horloge (fh),

    — des moyens (37) générateurs d'un signal analogique (Af) représentatif de l'écart de fréquence et de phase entre lesdits premier et deuxième signal à fréquence intermédiaire, lesdits moyens générateurs délivrant ledit signal analogique (Af) à ladite entrée de commande (10) de l'oscillateur à quartz à fréquence ajustable.

6. Dispositif selon la revendication 5, caractérisé en ce que lesdits moyens (30) générateurs d'un signal oscillateur local sont asservis en phase avec ledit deuxième signal base de temps (fb2).

7. Dispositif selon la revendication 6, caractérisé en ce que lesdits moyens (30) générateurs d'un signal oscillateur local sont constitués par un synthétiseur de fréquence, la fréquence du deuxième signal à fréquence intermédiaire f2 étant voisine de 10 Hz.

8. Dispositif selon l'une des revendications 5 à 7, caractérisé en ce que en vue d'assurer un asservissement en fréquence du premier signal base de temps (fb1) par rapport au deuxième signal base de temps (fb2) lesdits moyens de comptage-décomptage (36) comportent :

    — un circuit logique (3600) d'élaboration des signaux logiques B1.$\overline{B2}$ et B2.$\overline{B1}$, produit logique des signaux B1 et $\overline{B2}$ et de B2 et $\overline{B1}$ respectivement,

    — une première et une deuxième porte OU (364), (365) recevant chacune le signal d'horloge fh et les signaux B1.$\overline{B2}$ respectivement B2.$\overline{B1}$,

    — un compteur-décompteur (366) recevant sur l'entrée de comptage le signal logique délivré par la deuxième porte OU (365) et sur l'entrée de décomptage le signal délivré par la première porte OU (364),

    — un circuit (367) générateur d'impulsion de fin de comptage des N périodes délivrant en fin de comptage de N périodes du premier et du deuxième signal à fréquence intermédiaire f1, f2 une impulsion de réinitialisation ou remise à zéro (RAZ), lesdits moyens (37) générateurs d'un signal analogique (Af) consistant en une mémoire tampon (370) et un convertisseur numérique analogique (371).

9. Dispositif selon la revendication 8, caractérisé en ce que en vue d'assurer en outre un asservissement en phase du premier signal base de temps (fb1) par rapport au deuxième signal base de temps (fb2), lesdits moyens de comptage-décomptage (36) comportent en outre :

    — un circuit (368) duplicateur du signal de fréquence d'horloge (fh) permettant d'engendrer un premier (fh1) et un deuxième (fh2) signal d'horloge dupliqué de fréquence différente,

    — des moyens (369) de discrimination d'une période parmi p du deuxième signal, ces moyens délivrant un signal logique (hp) d'état déterminé pendant toute la durée de ladite période d'ordre p ainsi discriminée,

    — des moyens (370) de comptage pendant ladite période d'ordre p d'un nombre nφ de périodes de chacun desdits premier (fh1) et deuxième (fh2) signal d'horloge dupliqué, de façon à délivrer un premier et un deuxième signal de consigne de phase φ1, φ2, ledit signal de consigne de phase φ1 étant délivré à l'entrée de la deuxième porte OU (365) et le signal de consigne de phase φ2 étant délivré à l'entrée de la première porte OU (364).

10. Dispositif selon l'une des revendications 5 à 7, caractérisé en ce que, en vue de permettre la mise en oeuvre de moyens d'asservissement à constante de temps séquentiellement variable, lesdits premiers (33) et deuxièmes (34) moyens de comptage et lesdits moyens (35) générateurs du signal d'horloge fh comportent un diviseur de fréquence programmable dont le port d'entrée (3300,3400,3500) est relié à un circuit de commande (39).

11. Dispositif selon la revendication 10, caractérisé en ce que, en vue d'assurer le pilotage de la constante de temps desdits moyens d'asservissement (3) selon une séquence de variation déterminée, ledit circuit de commande (39) est constitué par un circuit logique de commande ou par un microprocesseur.

12. Dispositif selon l'une des revendications 10 ou 11, caractérisé en ce que en vue d'assurer le pilotage de la constante de temps desdits moyens d'asservissement (3) selon une séquence de variation déterminée, lesdits moyens d'asservissement (3) comportent en outre :

— des troisièmes moyens de changement de fréquence (130) recevant d'une part ledit premier fb1 et deuxième fb2 signal base de temps pour délivrer un signal de battement de fB dont l'amplitude est proportionnelle à la phase φ dudit premier par rapport audit deuxième signal de base de temps fb1, fb2, ceux-ci étant asservis en fréquence,

— des moyens amplificateurs (131) permettant d'obtenir un signal de battement fB amplifié,

— des moyens comparateurs (134) à double seuil de valeur de phase φm1, φm2, ledit comparateur (134) délivrant un signal logique à deux états, un premier état correspondant à une valeur de phase φ comprise entre lesdites valeurs de seuil de phase φm1 et φm2 et un deuxième état, complémenté par rapport au premier état, correspondant à une valeur de phase extérieure à l'intervalle de phase défini par les valeurs de seuil de phase φm1 et φm2, ledit signal logique étant délivré à un port d'entrée (390) dudit circuit de commande (39), de façon à permettre un asservissement de ladite valeur de phase φ entre les deux dites valeurs de seuil de phase φm1 et φm2.

13. Dispositif selon la revendication 12, caractérisé en ce que ledit circuit de commande (39) comporte un système de codage (391), par l'opérateur utilisateur du dispositif de la valeur finale τf de la constante de temps finale des moyens d'asservissement (3), ledit circuit de commande (39) permettant d'assurer à partir de la valeur initiale de déphasage φi entre lesdits premier et deuxième signal base de temps fb1, fb2, une convergence optimale d'accrochage de l'asservissement (3) par modification séquentielle de la valeur de la constante de temps τj pour atteindre la valeur finale τf, la valeur de déphasage φ étant maintenue dans l'intervalle défini par les valeurs de seuil de phase φm1 et φm2.

14. Dispositif selon les revendications 11 à 13, caractérisé en ce que ledit circuit de commande (39) étant constitué par un microprocesseur, celui-ci comporte une mémoire morte associée dans laquelle un programme de pilotage de variation séquentielle des rapports de division N des premiers (33) et deuxièmes (34) moyens de comptage d'un nombre N de périodes du premier f1, respectivement deuxième f2, signal à fréquence intermédiaire et M des moyens (35) générateurs du signal d'horloge fh est implanté.

15. Dispositif selon la revendication 14, caractérisé en ce que ledit programme comporte :

— une étape de mise en route et initialisation (1000, 1001) déclenchée par l'opérateur sur mise en marche du dispositif par l'intermédiaire du dispositif de commande (39), l'étape d'initialisation (1001) comportant notamment :

• la mise à valeur 1 du bit le plus significatif (MSB) du compteur-décompteur (366) les autres bits étant mis à zéro,

• le positionnement des diviseurs 330,340,35 à leur valeur minimale de façon à initialiser la constante de temps τ des moyens d'asservissement (3) à sa valeur initiale τi minimale,

• l'initialisation de variables de comptage A, B, C, lesdites variables étant définies comme :

A : l'ordre de la séquence de mesure de la valeur de n représentative de l'écart de fréquence ou de phase du premier et deuxième signal à fréquence intermédiaire, séquence temporelle correspondant à l'intervalle de temps entre deux impulsions d'écriture de ladite valeur n en mémoire tampon (370),

B : l'ordre de la séquence de mesure de la valeur de n pour laquelle de déphasage φ est compris entre les valeurs de seuil de déphasage φm1 et φm2,

C : le paramètre de définition de la valeur actuelle de la constante de temps en seconde τj de l'asservissement définie par : $\tau j = 25 \times 2^C$,

— une étape de test sur la valeur de φ déphasage entre le premier fb1 et le deuxième fb2 signal base de temps par rapport aux deux valeurs de seuil de phase φm1, φm2, test d'accrochage en phase, une réponse négative audit test permettant après incrémentation du compteur A d'effectuer une nouvelle séquence de mesure par retour en situation antérieure au test sur la phase (1002), une réponse positive audit test permettant de passer à une étape de vérification d'accrochage de l'asservissement en phase,

— une étape d'incrémentation (1004) desdits paramètres A et B permettant le passage à une mesure successive et à un test (1005) de stabilisation de phase sur le nombre nφ de mesures pour lesquelles le test d'accrochage en phase (1002) est satisfait, une réponse négative au test (1005) permettant le retour à une situation de nouvelle mesure préalable au test (1002),

— une étape (1006) d'incrémentation des rapports de division N et M des premiers (33) et deuxièmes (34) moyens de comptage et moyens (35) générateurs du signal d'horloge fh sur réponse positive au test de stabilisation de phase (1005),

— une étape de réinitialisation (1007) des paramètres A et B,

— Une étape de test (1008) de comparaison de C, représentatif de la valeur de la constante de temps actuelle τj de l'asservissement, à la valeur finale D introduite par codage par l'opérateur, une réponse négative audit test (1008) conduisant à une étape d'incrémentation de C puis à un retour à une étape de mesure de phase préalable au test de comparaison de phase (1002) et une réponse positive audit test (1008) conduisant à un nouveau test (1010) de comparaison de la valeur de phase φ aux valeurs de seuil de phase φm1 et φm2 une réponse positive audit test (1010) ramenant à une étape de nouveau test (1010), le système étant asservi, et une réponse négative audit test (1010) conduisant à une étape de décrémentation (1012) du paramètre C de façon à se ramener en situation antérieure, la valeur de la constante de temps des moyens d'asservissement (3) étant ramenée à la valeur τj − 1 = 25 × 2 $^{C-1}$ et le système étant ramené, suite à ladite décrémentation (1012), à une étape de mesure de phase antérieure à la situation de test (1002).

## Patentansprüche

1. Referenzzeitvorrichtung mit konstanter Stabilität für Kurz- und Langzeitmessung mit :

— einem ersten Erzeuger (1) eines ersten Zeit-Basis-Signales (fb1) mit konstanter Stabilität für Kurzzeitmessungen,

— einem zweiten Erzeuger (2) eines zweiten Zeit-Basis-Signales (fb2) mit konstanter Stabilität für Langzeitmessungen,

— einer Regeleinrichtung (3) für das erste und/oder das zweite Zeit-Basis-Signal im Verhältnis zum zweiten oder ersten Zeit-Basis-Signal, wobei dieses erste (fb1) und zweite (fb2) Zeit-Basis-Signal dieselbe Basis-Frequenz oder harmonische Frequenzen aufweisen, dadurch **gekennzeichnet**, daß die Regeleinrichtung (3) eine Zeitkonstante vorgibt, die dem Übergangsbereich zwischen Kurzzeit- und Langzeitmessung entspricht.

2. Vorrichtung nach Anspruch 1, dadurch **gekennzeichnet**, daß der erste Erzeuger (1) des ersten Zeit-Basis-Signales aus einem Quarzoszillator hoher Stabilität besteht.

3. Vorrichtung nach Anspruch 1 oder 2, dadurch **gekennzeichnet**, daß der zweite Erzeuger (2) des zweiten Zeit-Basis-Signales aus einer Cäsium-Uhr besteht.

4. Vorrichtung nach Anspruch 2 oder 3, dadurch **gekennzeichnet**, daß die Regeleinrichtung (3) des ersten oder zweiten Zeit-Basis-Signals im Verhältnis zum zweiten oder ersten Zeit-Basis-Signal eine Regelung dieses ersten Zeit-Basis-Signales (fb1) abhängig vom zweiten Zeit-Basis-Signal ausführt, wobei der erste Erzeuger des ersten Zeit-Basis-Signals aus einem Quarzoszillator einstellbarer Frequenz mit einem Steuereingang (10) besteht.

5. Vorrichtung nach Anspruch 4, dadurch **gekennzeichnet**, daß die Regeleinrichtung aufweist:

— eine erste Einrichtung (31) zum Ändern der Frequenz des ersten Zeit-Basis-Signales,

— eine zweite Einrichtung (32) zum Ändern der Frequenz des zweiten Zeit-Basis-Signals,

— einen Erzeuger (30) eines lokalen Oszillator-Referenzsignales zum Erzeugen und Ausgeben eines lokalen Oszillator-Signales der Frequenz foL, welche der ersten und der zweiten Einrichtung zum Ändern der Frequenz gemeinsam ist, wobei diese Änderungseinrichtungen ein erstes und ein zweites Zwischen-Frequenz-Signal (f1 bzw. f2) ausgeben, das jeweils der Frequenz und der Phase des ersten (fb1) bzw. des zweiten (fb2) Zeit-Basis-Signals entspricht,

— einen ersten (33) und einen zweiten (34) Zähler zum Zählen von N Perioden des ersten bzw. zweiten Zwischen-Frequenz-Signales der Frequenz (f1, f2), der ein logisches Signal (B1, B2) entsprechend der Zählung der N Perioden des ersten und zweiten Zwischen-Frequenz-Signales (f1, f2) ausgibt,

— einen Erzeuger (35) eines Clock-Signales (fh), dessen Frequenz eine harmonische Frequenz der Frequenz des ersten Zeit-Basis-Signales (fb1) ist,

— einen Aufwärts-/Abwärts-Zähler (36), der ermöglicht, einen Wert n entsprechend der Frequenz- oder Phasenabweichung des ersten Zwischen-Frequenz-Signales vom zweiten Zwischen-Frequenz-Signal zu bestimmen, wobei das Aufwärts- oder Abwärts-Zählen abhängig vom Clock-Signal (fh) ausgeführt wird,

— einen Analog-Signal-Erzeuger (37) abhängig von der Frequenz- und Phasenabweichung zwischen dem ersten und zweiten Zwischen-Frequenz-Signal, wobei dieser Erzeuger das Analog-Signal (Af) an den Steuereingang (10) des Quarzoszillators einstellbarer Frequenz ausgibt.

6. Vorrichtung nach Anspruch 5, dadurch **gekennzeichnet**, daß der Erzeuger (30) eines lokalen Oszillator-Signales phasengleich mit dem zweiten Zeit-Basis-Signal (fb2) regelbar ist.

7. Vorrichtung nach Anspruch 6, dadurch **gekennzeichnet**, daß der Erzeuger (30) eines lokalen Oszillator-Signales aus einem Frequenz-Generator besteht, wobei die Freqenz des zweiten Zwischen-Frequenz-Signales (f2) ungefähr gleich 10 Hz ist.

8. Vorrichtung nach einem der Ansprüche 5 bis 7, dadurch **gekennzeichnet**, daß zum Sicherstellen einer Frequenzregelung des ersten Zeit-Basis-Signales (fb1) im Verhältnis zum zweiten Zeit-Basis-Signal (fb2) der Aufwärts-/Abwärts-Zähler (36) aufweist:

— einen logischen Schaltkreis (3600) zum Erzeugen der logischen Signale (B1.B2) und (B2.B1), die das Produkt aus B1 und B2 bzw. B2 und B1 sind,

— ein erstes und ein zweites Gatter OU (364, 365), die jeweils das Clock-Signal (fh) und das Signal (B1.$\overline{B2}$) bzw. (B2.$\overline{B1}$) empfangen,

— einen Aufwärts-/Abwärts-Zähler (366), an dessen Aufwärts-Zähleingang das logische Ausgangssignal des zweiten Gatters OU (365) und an dessen Abwärts-Zähleingang das Ausgangssignal des ersten Gatters OU (364) anliegt,

— einen Schaltkreis (367) zum Erzeugen eines Signales am Ende der Zählung von N Perioden, das nach dem Zählen von N Perioden des ersten und des zweiten Zwischen-Frequenz-Signales (f1, f2) einen Impuls zum Reinitialisieren oder Rücksetzen auf Null (RAZ) ausgibt, wobei der Erzeuger (37) eines Analog-Signales (Af) aus einem Pufferspeicher (370) und einem A/D-Wandler (371) besteht.

9. Vorrichtung nach Anspruch 8, dadurch **gekennzeichnet**, daß zum weiteren Sicherstellen einer Phasenregelung des ersten Zeit-Basis-Signales (fb1) im Verhältnis zum zweiten Zeit-Basis-Signal (fb2) der Aufwärts-/Abwärts-Zähler (36) weiterhin aufweist:

— einen Multiplizierer-Schaltkreis (268) für das Frequenz-Signal (fh) zum Erzeugen eines ersten (fh1) und eines zweiten (fh2) vervielfachten Clock-Signals unterschiedlicher Frequenz,

— eine Vorrichtung (369) zum Diskriminieren einer von p Perioden des zweiten Signales, wobei diese Vorrichtung ein logisches Signal hp des festgestellten Zustandes während der gesamten Dauer dieser Periode der Ordnung p ausgibt,

— eine Einrichtung (370) zum Zählen von nΦ Perioden des ersten (fh1) und des zweiten (fh2) vervielfachten Clock-Signales während dieser Periode pter Ordnung um ein erstes und ein zweites Phasen-Befehls-Sifnal Φ1, Φ2 auszugeben, wobei das Phasen-Befehls-Signal Φ1 auf den Eingang des zweiten Gatters OU (365) und das Phasen-Befehls-Signal Φ2 auf den Eingang des ersten Gatters OU (364) gegeben wird.

10. Vorrichtung nach einem der Ansprüche 5 bis 7, dadurch **gekennzeichnet**, daß zum Aktivieren der Regeleinrichtung in konstanten einstellbaren Intervallen der erste (33) und der zweite (34) Zähler und der Erzeuger (35) eines Clock-Signales (fh) einen programmierbaren Frequenzteiler aufweisen, dessen Eingangsport (3300, 3400, 3500) mit einem Steuerschaltkreis (39) verbunden ist.

11. Vorrichtung nach Anspruch 10, dadurch **gekennzeichnet**, daß zum Sicherstellen der Steuerung der Zeitkonstanten der Regeleinrichtung (3) nach einer festgelegten Variations-Sequenz der Steuerschaltkreis (39) aus einem logischen Steuerschaltkreis oder einem Mikroprozessor besteht.

12. Vorrichtung nach Anspruch 10 oder 11, dadurch **gekennzeichnet**, daß zum Sicherstellen der Steuerung der Zeitkonstanten der Regeleinrichtung (3) nach einer festgelegten Variations-Sequenz die Regeleinrichtung (3) weiterhin aufweist:

— eine dritte Frequenz-Veränderungseinrichtung (130), die einerseits das erste (fb1) und das zweite (fb2) Zeit-Basis-Signal empfängt, um ein Pulssignal (fB) auszugeben, dessen Amplitude proportional zur Phase Φ des ersten im Verhältnis zum zweiten Zeit-Basis-Signal (fb1, fb2) ist, wobei beide Signale frequenzgeregelt sind,

— einen Verstärker (131) zum Verstärken des Pulssignales (fB),

— einen Komparator (134), dessen Schwellwert das Doppelte der Phasen Φm1, Φm2 beträgt, wobei dieser Komparator (134) ein logisches Signal entsprechend zweier Zustände ausgibt, von denen ein erster Zustand einem Phasenwert Φ zwischen den Phasenschwellwerten Φm1 und Φm2 entspricht und ein zweiter zum ersten Zustand komplementärer Zustand einem Phasenwert außerhalb des durch die Phasen-Schwellwerte Φm1 und Φm2 definierten Phasenintervalles, und dieses logische Signal an einen Eingangsport (390) des Steuerschaltkreises (39) ausgegeben wird, so daß eine Regelung des Phasenwertes Φ zwischen den Zwei-Phasen-Schwellwerten Φm1 und Φm2 möglich ist.

13. Vorrichtung nach Anspruch 12, dadurch **gekennzeichnet**, daß der Steuerschaltkreis (39) ein Kodierungssystem (391) aufweist, das durch den Bediener/Benutzer der Vorrichtung mit einem Endwert τf für die End-Zeitkonstante der Regeleinrichtung (3) kodierbar ist, wobei dieser Steuerschaltkreis (39) es ausgehend vom Initialisierungswert für die Phasenverschiebung Φi zwischen dem ersten und dem zweiten Zeit-Basis-Signal (fb1, fb2) ermöglicht, eine optimale Konvergenz des Einschwingverhaltens der Regelung (3) durch sequentielles Verändern des Wertes der Zeitkonstante τj auf den Endwert τf hin sicherzustellen, wobei der Wert der Phasenverschiebung Φ im definierten Intervall zwischen den Phasen-Schwellwerten Φm1 und Φm2 liegt.

14. Vorrichtung nach einem der Ansprüche 11 bis 13, dadurch **gekennzeichnet**, daß der Steuerschaltkreis (39) aus einem Mikroprozessor besteht, der einen zugeordneten Festspeicher aufweist, in dem ein Steuerprogramm zum sequentiellen Variieren des Teilungsverhältnisses N des ersten (33) und zweiten (34) Zählers zum Zählen von N Perioden des ersten (f1) bzw. zweiten (f2) Zwischen-Frequenz-Signales und M des Erzeugers (35) des Clock-Signales (fh) implementiert ist.

15. Vorrichtung nach Anspruch 14, dadurch

gekennzeichnet, daß dieses Programm aufweist :

— eine Routine zum Starten und Initialisieren (1000, 1001), die vom Bediener durch Inbetriebsetzen der Vorrichtung mittels der Steuereinrichtung (39) ausgelöst wird, wobei die Initialisierungs-Routine (1001) insbesondere aufweist :

— "1" Setzen des höchstwertigen Bits (MSB) des Aufwärts-/Abwärts-Zählers (366) und "0" Setzen der übrigen Bits,

— Einstellen der Teller (330, 340, 35) auf ihren minimalen Wert und damit Initialisieren der Zeitkonstanten $\tau$ der Regeleinrichtung (3) auf ihren minimalen Anfangswert $\tau i$,

— Initialisieren der Zähler-Variablen A, B, C, die definiert sind als :

A : Ordnung n der Meßwertfolge entsprechend der Frequenz- oder Phasenabweichung des ersten und zweiten Zwischen-Frequenz-Signales, wobei eine temporäre Folge dem Zeitintervall zwischen zwei Schreibimpulsen des Wertes n im Pufferspeicher (370) entspricht,

B : Ordnung n der Meßwertfolge, für die die Phasenverschiebung $\Phi$ zwischen den Schwellwerten für die Phasenverschiebung $\Phi m1$ und $\Phi m2$ liegt,

C : Parameter für die Definition des aktuellen Wertes der Zeitkonstanten $\tau f$ der Regelung in Sekunden, mit $\tau j = 25 \times 2^C$,

— eine Abfrage-Routine, die den Wert $\Phi$ der Phasenverschiebung zwischen dem ersten (fb1) und dem zweiten (fb2) Zeit-Basis-Signal im Verhältnis zu den beiden Phasenschwellwerten $\Phi m1$ und $\Phi m2$ und also das Phasen-Einschwingverhalten prüft, wobei ein negatives Abfregeergebnis nach dem Inkrementieren des Zählers (A) durch Rücksprung zur Ausgangssituation vor dem Prüfen der Phase (1002) eine neue Meßfolge bewirkt, ein positives Abfrageergebnis zu einer Verifikations-Routine des Einschwingverhaltens der Phasenregelung verzweigt,

— eine Routine zum Inkrementieren (1004) der Parameter A und B, die zu sukzessivem Messen und Prüfen (1005) der Fasenstabilität aufgrund der n$\Phi$ Messungen, mit denen die Überprüfung des Phasen-Einschwingverhaltens (1002) zufriedenstellend ist, verzweigt, wobei ein negatives Prüfergebnis (1005) den Rücksprung zur Ausgangssituation und erneute Messung in der Prüfroutine (1002) bewirkt,

— eine Routine (1006) zum Inkrementieren der Teilungsverhältnisse N und M des ersten (33) und des zweiten (34) Zählers und des Erzeugers (35) des Clock-Signales (fh) bei positivem Prüfergebnis der Phasenstaibität (1005),

— eine Routine zum Initialisieren (1007) der Parameter A und B,

— eine Abfrageroutine (1008), in der C, der Wert, der der aktuellen Zeitkonstante $\tau j$ der Regelung entspricht, mit dem Endwert D, welcher durch die Kodierung des Bedieners festgelegt ist, verglichen wird, wobei ein negatives Abfrageergebnis (1008) zum Inkrementieren von C und dann zum Rücksprung zur vorherigen Phasenmessung in der Phasen-Abfrage-Routine (1002), und ein positives Abfrageergebnis (1008) zu einer neuen Überprüfung (1010) führt, worin der Wert der Phase $\Phi$ mit den Phasenschwellwerten $\Phi m1$ und $\Phi m2$ verglichen, bei positivem Prüfergebnis (1010) die Überprüfung (1010) wiederholt wird, wobei das System geregelt ist, und ein negatives Prüfergebnis (1010) zu einer Routine (1012) führt, in der der Parameter C so dekrementiert wird, daß er seinen vorherigen Wert annimmt, der Wert der Zeitkonstanten der Regeleinrichtung (3) zu $\tau j - 1 = 25 \times 2^{C-1}$ wird, und das System nach dem Dekrementieren (1012) zu einer vorherigen Phasenmeß-Routine in der Prüf-Routine (1002) zurückspringt.

## Claims

1. A clocking device of substantially constant stability for the short-term and long-term measurement of time, comprising :

— first generating means (1) of a first clocking signal (fb1) with substantially constant stability for short-term measurements of time,

— second generating means (2) of a second clocking signal (fb2) of substantially constant stability for long-term measurements of time,

— means (3) for the automatic locking of one of the said first or second clocking signals to the other, second or first clocking signal,said first (fb1) and second (fb2) clocking signal having the same base frequency or harmonic frequencies, characterized in that said automatic means (3) have a time constant corresponding to the transition zone between the short-term and long-term measurements.

2. A device according to claim 1 characterized in that said first generating means (1) of the first clocking signal are constituted by a highly stable quartz oscillator.

3. A device according to any of the claims 1 or 2 characterized in that said second generating means (2) of the second clocking signal are constituted by a caesium clock.

4. A device according to any of the preceding claims 2 and 3, characterized in that said means (3) for the automatic locking of one of said first or second clocking signals to the other, second or first, clocking signal achieves an automatic locking of said first clocking signal (fb1) to said second clocking signal (fb2), said first generating means of the first clocking signal being constituted by an adjustable frequency quartz oscillator having a control input (10).

5. A device according to claim 4 characterized in that said automatic locking means comprise :

— first means (31) for changing the frequency of the first clocking signal,

— second means (32) for changing the frequency of the second clocking signal,

— means (30) for generating a local oscillator reference signal enabling the creation and delivering of a local oscillator signal with a frequency foL, common to said first and second frequency changing means, which deliver a first and second intermediate frequency signal, with respective frequencies f1 and f2, each representing the frequency and phase of the said first (fb1) and second (fb2) clocking signals respectively,

— first means (33) and second means (34) for counting a number N of periods of said first and second intermediate frequency signals respectively, of frequencies f1, f2, giving logic signals, B1, B2, representing the counting of N periods of the first and second intermediate frequency (f1, f2) signals,

— means (35) for generating a clock signal (fh), the frequency of which is a harmonic frequency of the frequency of the first clocking signal (fb1),

— count/countdown means (36) used to establish a value n representing the frequency or phase deviation of the first intermediate frequency signal with respect to the second intermediate frequency signal, the counting or countdown being done with respect to the clock signal (fh),

— means (37) for generating an analog signal (Af) representing the frequency and phase deviation between the first and second intermediate frequency signals, said generating means delivering said analog signal (Af) to said control input (10) of the adjustable frequency quartz oscillator.

6. A device according to claim 5 characterized in that said means (30) for generating a local oscillator signal are automatically locked in phase with said second (fb2) clocking signal.

7. A device according to claim 6 characterized in that said means (30) for generating a local oscillator signal are constituted by a frequency synthesizer, the frequency of the second intermediate frequency signal being close to 10 Hz.

8. A device according to any one of the claims 5 to 7 characterized in that, in order to automatically lock the frequency of the first clocking signal (fb1) with that of the second clocking signal (fb2), said count/countdown means (36) comprise :

— a logic circuit (3600) for the preparation of the logic signals B1.$\overline{B2}$ and B2.$\overline{B1}$, the logic product of the signals B1 and $\overline{B2}$ and B2 and $\overline{B1}$ respectively,

— a first and a second OR gate (364), (365) each receiving the clock signal fh and the signals B1.$\overline{B2}$ and B2.$\overline{B1}$ respectively,

— a count/countdown unit (366) receiving, at the counting input, the logic signal delivered by the second OR gate (365) and at the countdown input the signal delivered by the first OR gate (364),

— a circuit (367) generating pulses at the end of the counting of N periods, delivering at the end of the counting of N periods of the first and second intermediate frequency signals, f1, f2, a re-initializing or zero-setting pulse (RAZ), said means (37) for generating an analog signal (Af) consisting of a buffer memory (370) and a digital/analog converter (371).

9. A device according to claim 8 characterized in that, in order to further provide for automatic phase locking of the first clocking signal (fb1) with the second clocking signal (fb2), said count/countdown means (36) further comprise :

— a clock frequency fh signal duplicating circuit (368) used to create a first (fh1) and second (fh2) duplicated clock signal of different frequencies,

— means (369) to discriminate a period, among p, of the second signal, said means delivering a determined logic state signal (hp) throughout the duration of said pth period thus discriminated,

— means (370) for the counting, during the said pth period, of a number n$\phi$ of periods of each of said first (fh1) and second (fh2) duplicated clock signals so as to give a first and second phase setting signal $\phi$1, $\phi$2, said first phase setting signal $\phi$1 being delivered to the input of the second OR gate and the phase setting signal o2 being delivered to the input of the first OR gate (364).

10. A device according to any of the claims 5 to 7 characterized in that, in order to implement automatic locking means with a sequentially variable time constant, said first (33) and second (34) counting means and said means (35) for generating the clock signal fh comprise a programmable frequency divider with its input gate (3300, 3400, 3500) connected to a control circuit (39).

11. A device according to claim 10 characterized in that, in order to provide for the control of the time constant of said automatic locking means (3) according to a determined variation sequence, said control circuit (39) is constituted by a control logic circuit or a microprocessor.

12. A device according to either of the claims 10 or 11 characterized in that, in order to provide for the control of the time constant of said automatic locking means (3) according to a determined variation sequence, said automatic locking means (3) further comprise :

— third frequency changing means (130) receiving, firstly, said first clocking signal fb1 and second clocking signal fb2 to deliver a beat signal fB, the amplitude of which is proportionate to the phase o of said first clocking signal with respect to said second clocking signal, fb1, fb2, said clocking signals being automatically locked in frequency,

— amplifier means (131) used to obtain an amplified beat signal fB,

— comparator means (134) with a dual phase value threshold, $\phi$m1 and $\phi$m2, said comparator giving a two-state logic signal, a first state corresponding to a phase $\phi$ value ranging between said phase threshold values, $\phi$m1 and $\phi$m2, and a second state, complemented with respect to the first state, corresponding to a phase value external to the phase interval defined by the phase threshold values, $\phi$m1 and $\phi$m2, said logic signal being delivered to an input gate (390) of said control circuit to enable an automatic locking of said phase value $\phi$ between the two said phase threshold values, $\phi$m1 and $\phi$m2.

13. A device according to claim 12 characterized in that said control circuit (39) comprises an system (391) for the encoding, by the operator using the device, of the final value if of the final time constant of the automatic locking means (3), said control circuit (39) being used to obtain, from the initial phase shift value oi between said first and second clocking signals, fb1, fb2, an optimal convergence of the capture of the automatic locking (3) through sequential modification of the value of the time constant $\tau$j to reach the final value $\tau$f, the phase shift value $\phi$ being held in the interval defined by the phase threshold values $\phi$m1 and $\phi$m2.

14. A device according to the claims 11 to 13 characterized in that said control circuit (39) being constituted by a microprocessor, said microprocessor comprises an associated read-only memory in which a program is implanted to control the sequential variation of the division ratio N of the first and second counting means of a number N of periods of the first (33) and second (34) intermediate frequency signals, of frequencies f1 and f2 respectively, and of the division ratio M of the generating means (35) of the clock signal fh.

15. A device according to claim 14 characterized in that said program comprises :

— a starting up and initializing step (1000, 1001) triggered by the operator when the device is turned on through the control device (39) said initializing step (1001) comprising, in particular :

* the setting at 1 of the most significant bit (MSB) of the count/countdown unit (366), the other bits being set at zero,

* the positioning of the dividers 330, 340, 35 at their minimum value so as to initialize the time constant $\tau$ of the automatic locking means (3) at its minimum initial value $\tau$i,

* the initializing of the counting variables A, B, C, said variables being defined as :

A : the order of the sequence to measure the value of n representing the frequency or phase deviation between the first and second intermediate frequency signals, temporal sequence corresponding to the time interval between two pulses for writing said value n in the buffer memory (370),

B : the order of the sequence to measure the value of n for which the phase shift $\phi$ ranges between the phase shift threshold values $\phi$m1 and $\phi$m2,

C : the parameter for defining the current value of the automatic locking time constant, in seconds, $\tau$j defined by : $\tau j = 25 \times 2^C$,

— a step for testing the phase shift value o between the first fb1 and second fb2 clocking signals and the two phase threshold values om1, om2, a phase capture test, a negative response to said test enabling, after incrementation of the counter A, the execution of a fresh measuring sequence by a return to the situation prior to the test (1002) on the phase, a positive response to said test enabling the passage to a step for checking the capture of the automatic phase lock,

— a step (1004) for incrementing said parameters A and B, enabling the passage to a successive measurement and to a phase stabilizing test (1005) on the number no of measurements for which the phase capture test (1002) is satisfactory, a negative response to the test (1005) enabling a return to a fresh measuring situation prior to the test (1005),

— a step (1005) for incrementing the division ratios N and M of the first (33) and second (34) counting means and clock signal generating means (3S) upon a positive response to the phase stabilizing test (1005),

— a step (1007) for re-initializing the parameters A and B,

— a step (1008) for testing the comparison of C, representing the value of the current time constant $\tau$j of the automatic locking, with the final value D introduced by encoding by the operator, a negative response to said test (1008) leading to a step for the incrementation of C and then to a return to a phase measuring step prior to the phase comparison test (1002), and a positive response (1008) to said test leading to a fresh test (1010) for comparing the phase value $\phi$ with the phase threshold values, $\phi$m1 and $\phi$m2, a positive response to said test (1010) leading to a new test step (1010), the system being automatically locked, and a negative response to said test (1010) leading to a step (1012° for the decrementation of the parameter C so as to return to the prior situation, the value of the time constant of the automatic locking means (3) being brought to

the value $\tau j - 1 = 25 \times 2^{C-1}$ and the system being brought back, after said decrementation, to a phase measuring step prior to the test (1002) situation.

## FIG_1

## FIG_2b

FIG_2a

S = Séparateur
PS = Circuit diviseur de puissance

Synthèse signal local

Sorties Utilisation

FIG.3a

S = Séparateur
PS = Circuit Diviseur de puissance

## FIG_3b

## FIG_5

FIG. 4

1000 — DEMARRAGE — Bouton poussoir START

1001 — Charge Accum MSB.1 / RAZ. S1.B2.A.B.C. / Constante de temps minimum

Commande facteur de division

L'incrémentation des compteurs A, B, C est produite par le top de change de la mémoire tampon.

non

A=3 — oui — A=0 B=0

1002 — $P_1 < \varphi < \varphi_2$ — non — A=A+1

1003

oui

1004 — A=A+1 B=B+1

1005 — A=3 — non — A=0 B=0

oui

1006 — B=3 — non

oui

1012 — C=C-1 N=N/2 M=M/2

1009

C=C+1

N=2N M=2M

101 — ALARME — Fermeture d'un relais + memorisation défaut

1007 — A=0 B=0

Comparaison à la valeur de la roue codeuse

1008 — C=D — oui

non

1010 — $\varphi_{m1} < \varphi < \varphi_{m2}$ — oui

non

EP 0 289 385 B1

23